# EUROPEAN PATENT APPLICATION

(11) **EP 4 819 200 A1**
(43) Date of publication of application: **07.10.2026**
(21) Application number: 24897599.7
(22) Date of filing: 27.11.2024
(51) Int. Cl.: H01L 21/60, C22C 21/00, C22C 21/02, C22F 1/00, C22F 1/04

(54) **AL BONDING WIRE OR AL BONDING RIBBON**

(30) Priority: 27.11.2023 WO PCT/JP2023/042366; 27.11.2023 WO PCT/JP2023/042369; 27.11.2023 WO PCT/JP2023/042371; 27.11.2023 WO PCT/JP2023/042373; 27.11.2023 WO PCT/JP2023/042374; 04.06.2024 WO PCT/JP2024/020313; 04.06.2024 WO PCT/JP2024/020314
(71) Applicant: NIPPON STEEL CHEMICAL & MATERIAL CO., LTD., Tokyo 103-0027 (JP); Nippon Micrometal Corporation, Iruma-shi Saitama 358-0032 (JP)
(72) Inventor: UNO, Tomohiro, Tokyo 100-8071 (JP); TAKAYAMA, Toru, Tokyo 100-8071 (JP); ODA, Daizo, Iruma-shi, Saitama 358-0032 (JP); ETO, Motoki, Iruma-shi, Saitama 358-0032 (JP)
(74) Representative: Grünecker Patent- und Rechtsanwälte PartG mbB
(86) International application number: PCT/JP2024/042020
(87) International publication number: WO 2025/115915

(57) **Abstract**

To provide an Al bonding wire or an Al bonding ribbon that can ensure favorable bonding strength even when used in a power semiconductor having a thin structure or a high-density element structure in which an element is arranged directly below an electrode. The Al bonding wire or the Al bonding ribbon contains 3.0% by mass or more and 20.0% by mass or less of Si, wherein, in a region observed by X-ray CT analysis, when a total volume of voids having an equivalent sphere diameter equal to or larger than 1 µm and smaller than 10 µm is defined as Vs and a total volume of a measurement region is defined as Vc, a ratio of Vs to Vc [Vs/Vc × 100 (%)] is equal to or larger than 0.02% and equal to or smaller than 4.00%, and when the number of Si phases having an equivalent circle diameter equal to or larger than 0.5 µm and equal to or smaller than 0.8 µm in an L cross-section (cross section in a center axis direction including a center axis) is defined as Ns and the number of Si phases having an equivalent circle diameter equal to or larger than 0.5 µm in the L cross-section is defined as Nc, a ratio of Ns to Nc [Ns/Nc × 100 (%)] is equal to or larger than 30% and equal to or smaller than 95%.

## Description

### TECHNICAL FIELD

The present invention relates to an Al bonding wire or an Al bonding ribbon. The present invention further relates to a semiconductor device obtained by using the Al bonding wire or the Al bonding ribbon.

### BACKGROUND ART

In a semiconductor device, electrodes formed on a semiconductor chip are connected with a lead frame or electrodes on a substrate via a bonding wire (wire material) or a bonding ribbon (bar material). In a power semiconductor device, used is a bonding wire or a bonding ribbon made mainly of aluminum (Al) as a material. A wire diameter of the Al bonding wire mainly falls within a range from 100 µm to 600 µm. A width of the Al bonding ribbon mainly falls within a range from 100 µm to 3000 µm, and a thickness thereof falls within a range from 50 µm to 600 µm. Herein, the Al bonding wire and the Al bonding ribbon are collectively referred to as an Al connection material.

In the power semiconductor device, silicon (Si) is often used as a material of a semiconductor chip, and an Al-Si alloy or an Al-Cu alloy is often used as a material of the electrode formed on the semiconductor chip. Power semiconductor devices using the Al bonding wire or the Al bonding ribbon are often used as large power equipment such as air conditioners and photovoltaic power generation systems, or as vehicle-mounted semiconductor devices.

A bonding method for the Al bonding wire or the Al bonding ribbon includes 1st bonding with the electrode on the semiconductor chip and 2nd bonding with the lead frame or the electrode on the substrate, and wedge bonding is used for both of them. The wedge bonding is a method for applying ultrasonic vibrations and loads to the Al bonding wire or the Al bonding ribbon via a jig (tool) made of metal, breaking surface oxide films of the Al bonding wire or the Al bonding ribbon and an electrode material to expose new surfaces, and performing solid phase diffusion bonding. This connection method is characterized in that the connection material is connected in a solid phase state without being melted, which is a bonding technique different from a welding technique of melting the connection material.

A next-generation power semiconductor device is required to stably operate for a long time as compared with a general-purpose power semiconductor device. The power semiconductor device operates while repeatedly turning on and off a current. When a current is supplied to a semiconductor chip made of Si via the Al bonding wire or the Al bonding ribbon, a temperature of a 1st bonding part rises. On the other hand, when supply of the current is stopped, the temperature of the 1st bonding part falls. In this way, the temperature of the 1st bonding part repeatedly rises and falls at the time when the power semiconductor operates. In that case at the 1st bonding part, thermal stress caused by a thermal expansion difference between the Al bonding wire or the Al bonding ribbon and the semiconductor chip is imposed repeatedly. In a case of using a connection material made only of high-purity Al, the Al bonding wire or the Al bonding ribbon is broken in a relatively short time due to thermal stress and it has been difficult to satisfy performance required for the next-generation power semiconductor device. Thus, in the next-generation power semiconductor, it is required to improve a lifetime of wire (or ribbon) bond accompanying a temperature rise and a temperature fall of the 1st bonding part (hereinafter, also referred to as "temperature cycle reliability").

To the requirement for the temperature cycle reliability, an Al bonding wire focused on improvement in mechanical strength is proposed. As a method for improving a mechanical characteristic of the Al bonding wire, there has been developed a method for adding a specific element to Al.

Patent Literature 1 discloses a bonding wire made of an Al alloy containing at least magnesium (Mg) and silicon (Si), wherein the total content of Mg and Si is equal to or larger than 0.03% by mass and equal to or smaller than 0.3% by mass. This Patent Literature discloses that lowering of bonding strength of the 1st bonding part is delayed in a thermal cycle test in a temperature range from 70°C to 120°C due to a high-strengthening effect exhibited by solid-solution strengthening of Mg or Si, and an effect of suppressing crack development exhibited by precipitated magnesium silicide (Mg₂Si).

Patent Literature 2 discloses a bonding wire made of an alloy containing 0.01 to 0.2% by mass of iron (Fe), 1 to 20 mass ppm of silicon (Si), and Al having purity of 99.997% by mass or more as a balance, in which a solid solution amount of Fe is 0.01 to 0.06%, a precipitation amount of Fe is 7 times or less the Fe solid solution amount, and the bonding wire has a fine structure having an average crystal grain size of 6 to 12 µm. This Patent Literature discloses that it is possible to suppress lowering of bonding strength of a 1st bonding part in a thermal shock test within a temperature range from -50°C to 200°C by uniformly dispersing intermetallic compound particles of Fe and Al in Al to improve mechanical strength of a matrix and further refining recrystallized grains.

Patent Literature 3 discloses a bonding wire made by melting an Al-Si alloy containing 0.1 to 5% by mass of silicon (Si), and Al and impurities as a balance, and jetting and rapidly cooling it to be formed in a thin line. This Patent Literature discloses that mechanical strength is improved by rapidly cooling the melted Al-Si alloy to finely and uniformly disperse Si.

### RELATED ART REFERENCE

### Patent Literature

Patent Literature 1: Japanese Patent Application Laid-open No. 2014-131010
Patent Literature 2: Japanese Patent Application Laid-open No. 2014-129578
Patent Literature 3: Japanese Patent Application Laid-open No. S59-57440

### SUMMARY OF INVENTION

As described above, the next-generation power semiconductor device is required to be able to withstand a longer-time use as compared with a general-purpose power semiconductor device. The temperature of the 1st bonding part repeatedly rises and falls at the time when the power semiconductor device operates. As a result, because the Al bonding wire or the Al bonding ribbon has a coefficient of linear thermal expansion larger than that of the semiconductor chip, there has been a case in which thermal stress is caused due to a difference between coefficients of linear thermal expansion thereof at the 1st bonding part, which finally causes fatigue breakdown of the Al bonding wire or the Al bonding ribbon. A temperature cycle test is one of the tests in an accelerated manner to evaluate a lifetime of wire (or ribbon) bond accompanying a temperature rise and a temperature fall at the 1st bonding part (temperature cycle reliability). The Al bonding wire or the Al bonding ribbon used for the next-generation power semiconductor is required to exhibit excellent temperature cycle reliability in the temperature cycle test.

Herein, for power semiconductors, a high-density element structure has been developed in which an element such as a diode is arranged directly below an electrode to be bonded. In such a high-density element structure, there is a concern about a risk that, when ultrasonic waves and loads are applied to bond a bonding wire or ribbon, the element directly below the electrode may be damaged. Also, in next-generation power elements that replace silicon (Si), which has been mainstream, use of silicon carbide (SiC) having high heat resistance is predicted to advance. In a connection for a SiC power semiconductor, a temperature cycle test that is more severe than a current temperature cycle test is required. To reduce substrate resistance of an SiC semiconductor and improve energy conversion efficiency, and to reduce an amount of use of an expensive material, it is considered that a demand for thinning of SiC will increase. When a bonding wire or a bonding ribbon is bonded by using a thin substrate, a risk that damage occurs in a semiconductor further increases.

As described above, in a development material of the Al bonding wire or the Al bonding ribbon having high reliability in which temperature cycle reliability is improved for a power semiconductor, there is a concern that a risk that damage occurs in a semiconductor increases. As a result of improving temperature cycle reliability, the material used has improved increase of strength and refinement of crystal grain etc.. Particularly, in a case of using an Al alloy that is highly strengthened by adding Si and the like thereto as a bonding wire or a bonding ribbon, there is a concern about problems such as that bonding strength at the time of 1st bonding is lowered due to hardness thereof, that a deformation shape becomes unstable due to bonding in which a load and ultrasonic output are increased, damage to an element, and generation of a crack. Although a temporary measure of adjusting ultrasonic vibrations and loads to reduce such damage is possible, as a result, bonding becomes insufficient, and a problem in that temperature cycle reliability is lowered arises.

On the other hand, in a shear test that is generally performed as evaluation of bonding strength of the 1st bonding part, shear fracture force is measured from a lateral direction. In a shear test, since fracture mainly occurs in a bonding wire or a bonding ribbon, in a high-strength bonding wire or bonding ribbon, apparent shear force is often evaluated to be high due to an influence of material strength. That is, in a high-strength material, even in a case in which apparent shear force of the 1st bonding part is high, metallic bonding with an electrode is insufficient at a bonding interface, and lowering of temperature cycle reliability occurs. Thus, instead of relying only on a numerical value of shear force of the 1st bonding part, it is required to perform bonding evaluation that more appropriately reflects an interface state and the like to obtain material design suitable for a high-reliability Al alloy for a power semiconductor on a basis of the evaluation.

The present invention has been made in view of the above problem, and an object thereof is to provide an Al bonding wire or an Al bonding ribbon that can ensure favorable bonding strength even when used in a power semiconductor having a thin structure or a high-density element structure in which an element is arranged directly below an electrode.

### MEANS FOR SOLVING PROBLEM

As a result of earnest investigation as to the problem described above, the present inventors have found that the problem described above can be solved by an Al bonding wire or an Al bonding ribbon containing 3.0% by mass or more and 20.0% by mass or less of Si, wherein, in a region observed by X-ray CT analysis, a ratio of a total volume of voids having an equivalent sphere diameter equal to or larger than 1 µm and smaller than 10 µm and a ratio of the number of Si phases having an equivalent circle diameter equal to or larger than 0.5 µm and equal to or smaller than 0.8 µm in an L cross-section (cross section in a center axis direction including a center axis) fall within respective specific ranges, and further investigated the problem based on such knowledge to complete the present invention.

That is, the present invention includes the following content.
<1> An Al bonding wire or an Al bonding ribbon containing 3.0% by mass or more and 20.0% by mass or less of Si, wherein
   in a region observed by X-ray Computed Topograpy (CT) analysis, when a total volume of voids having an equivalent sphere diameter equal to or larger than 1 µm and smaller than 10 µm is defined as Vs and a total volume of a measurement region is defined as Vc, a ratio of Vs to Vc [Vs/Vc × 100 (%)] is equal to or larger than 0.02% and equal to or smaller than 4.00%, and
   when the number of Si phases having an equivalent circle diameter equal to or larger than 0.5 µm and equal to or smaller than 0.8 µm in an L cross-section (cross section in a center axis direction including a center axis) is defined as Ns, and the number of Si phases having an equivalent circle diameter equal to or larger than 0.5 µm in the L cross-section is defined as Nc, a ratio of Ns to Nc [Ns/Nc × 100 (%)] is equal to or larger than 30% and equal to or smaller than 95%.
<2> The Al bonding wire or the Al bonding ribbon according to <1>, wherein, in a region observed by X-ray CT analysis, when a total number of voids having an equivalent sphere diameter equal to or larger than 1 µm and smaller than 7 µm is defined as Ps and a total number of voids having an equivalent sphere diameter equal to or larger than 1 µm is defined as Pc, a ratio of Ps to Pc [Ps/Pc × 100 (%)] is equal to or larger than 60% and equal to or smaller than 98%.
<3> The Al bonding wire or the Al bonding ribbon according to <1> or <2>, further containing 10 mass ppm or more and 800 mass ppm or less of one or more of Sr, Na, Dy, and B in total.
<4> The Al bonding wire or the Al bonding ribbon according to any one of <1> to <3>, further containing 100 mass ppm or more and 1500 mass ppm or less of one or more of Ni, Ti, Fe, and Cu in total.
<5> The Al bonding wire or the Al bonding ribbon according to any one of <1> to <4>, wherein a total concentration of elements other than Al, Si, Sr, Na, Dy, B, Ni, Ti, Fe, and Cu in the Al bonding wire or the Al bonding ribbon is equal to or smaller than 0.5 % by mass.
<6> The Al bonding wire or the Al bonding ribbon according to any one of <1> to <5>, wherein equivalent circle diameter of the Si phase and the number of the Si phases are values measured by using an SEM-EDS-EBSD apparatus.
<7> The Al bonding wire or the Al bonding ribbon according to any one of <1> to <6>, used for a semiconductor device.
<8> A semiconductor device comprising the Al bonding wire or the Al bonding ribbon according to any one of <1> to <7>.

### EFFECT OF THE INVENTION

According to the present invention, it is possible to provide an Al bonding wire or an Al bonding ribbon that can ensure favorable bonding strength even when used in a power semiconductor having a thin structure or a high-density element structure in which an element is arranged directly below an electrode, and a semiconductor device obtained by using the Al bonding wire or the Al bonding ribbon.

### BRIEF DESCRIPTION OF DRAWINGS

FIG. 1 is a schematic diagram for explaining, regarding an Al bonding wire, a measurement target surface (inspection surface) when measuring a small-diameter ratio of a Si phase. The measurement target surface is a cross section in a center axis direction including a center axis (L cross-section) of the Al bonding wire.
FIG. 2 is a schematic diagram for explaining, regarding an Al bonding ribbon, a measurement target surface (inspection surface) when measuring a small-diameter ratio of a Si phase. The measurement target surface is a cross section in a center axis direction including a center axis (L cross-section) of the Al bonding ribbon.
FIG. 3 is an example of a luminance histogram created when determining a threshold of luminance of a void or an outer space and a substance in X-ray CT analysis.
FIG. 4 is an example of a graph representing a number distribution of an equivalent circle diameter of the Si phase in the L cross-section.

### EMBODIMENT FOR CARRYING OUT THE INVENTION

Hereinafter, the present invention will be described in detail with reference to preferable embodiments thereof. While the drawings may be referred to for description, each of the drawings merely schematically illustrates shapes, sizes, and arrangement of constituent elements to the extent that the invention can be understood. The present invention is not limited to the following embodiments and examples, and may be optionally changed to be implemented as long as departing from CLAIMS of the present invention and equivalents.

### [Al bonding wire or Al bonding ribbon]

An Al bonding wire or an Al bonding ribbon according to the present invention is an Al bonding wire or an Al bonding ribbon containing 3.0% by mass or more and 20.0% by mass or less of Si, and is characterized in that,
in a region observed by X-ray Computed Topograpy (CT) analysis, when a total volume of voids having an equivalent sphere diameter equal to or larger than 1 µm and smaller than 10 µm is defined as Vs and a total volume of a measurement region is defined as Vc, a ratio of Vs to Vc [Vs/Vc × 100 (%)] (hereinafter, also referred to as a "minute void volume ratio") is equal to or larger than 0.02% and equal to or smaller than 4.00%, and
when the number of Si phases having an equivalent circle diameter equal to or larger than 0.5 µm and equal to or smaller than 0.8 µm in an L cross-section (cross section in a center axis direction including a center axis) is defined as Ns and the number of Si phases having an equivalent circle diameter equal to or larger than 0.5 µm in the L cross-section is defined as Nc, a ratio of Ns to Nc [Ns/Nc × 100 (%)] is equal to or larger than 30% and equal to or smaller than 95%.

As described above, in evaluation of a bonding property of the 1st bonding part, when fracture occurs inside the bonding wire or the bonding ribbon in the shear test, it is difficult to accurately evaluate a bonding property of a high-strength material. In this regard, as a method for evaluating bonding strength while suppressing an influence of material strength, it is conceivable to perform determination based on a value obtained by normalizing shear force with material strength. As a result of investigating a relation between the material strength and the bonding property and the like, the present inventors have found that it is effective to calculate a ratio obtained by dividing shear force (SH) by 0.2% proof stress (PS) in a tensile test (SH/PS, hereinafter referred to as a "shear force ratio"). When factors that govern a value of apparent shear force of the 1st bonding part are decomposed, the factors can be divided into net bonding strength and deformation resistance of the wire or the ribbon. The latter deformation resistance correlates with yield strength at which the wire or the ribbon yields and starts plastic deformation during the shear test. Accordingly, to evaluate net bonding strength, it has been devised to exclude an influence of yield strength of the wire or the ribbon from apparent shear force. As this yield strength, 0.2% proof stress, which is a strength value when elongation in the tensile test is 0.2%, is used.

That is, the present inventors have found that a bonding state can be evaluated more accurately by using the shear force ratio (SH/PS) normalized with 0.2% proof stress (PS). By showing shear force a high value, it can be determined that favorable bonding is obtained at a bonding interface. By using the shear force ratio (SH/PS) as an index, when the wire or the ribbon having a high shear force ratio is used, both favorable bonding strength and reduction of bonding damage can be achieved, and performance excellent in temperature cycle reliability can be exhibited, so that it can adapt to bonding of a power semiconductor having a thin structure or having an element arranged directly below an electrode.

As a result of further earnest investigation as to the problem described above, the present inventors have found that minute voids are contained in an Al-Si alloy wire or ribbon containing a high concentration of Si, that controlling a volume of the voids and further controlling the number distribution of an equivalent circle diameter of the Si phase are important for increasing the shear force ratio and obtaining favorable initial bonding, and that the Al bonding wire or the Al bonding ribbon is also excellent in temperature cycle reliability and a bonding shape.

The Al bonding wire or the Al bonding ribbon according to the present invention contains 3.0% by mass or more and 20.0% by mass or less of Si, and includes the Al phase in which Si is dissolved in Al as a solid solution and a Si phase formed by crystallization or precipitation of Si. In the Al phase, other additive elements may be dissolved as a solid solution in addition to Si. The Si phase is a general term for Si crystallized products and Si precipitates. The Si crystallized product is formed from a solution during solidification, and has a size of about 1 to 25 µm, which is coarse. On the other hand, the Si precipitate is formed from a solid state, and has a small size of about 0.1 µm to several micrometers. The Si phase has a smaller coefficient of linear thermal expansion than that of Al, contributes to reduction of a difference in coefficient of linear thermal expansion between the Al bonding wire or the Al bonding ribbon and the semiconductor chip, and may reduce thermal stress, so that it has an effect of improving temperature cycle reliability.

In the present invention, a "wire" and a "ribbon" are classified not by a shape but by a manufacturing method thereof. That is, the term "wire" refers to "a connection material manufactured by wire-drawing processing using a die", and the term "ribbon" refers to "a connection material manufactured by a rolling process". A "wire" usually has a circular cross-sectional shape, and a "ribbon" usually has a rectangular or substantially rectangular cross-sectional shape.

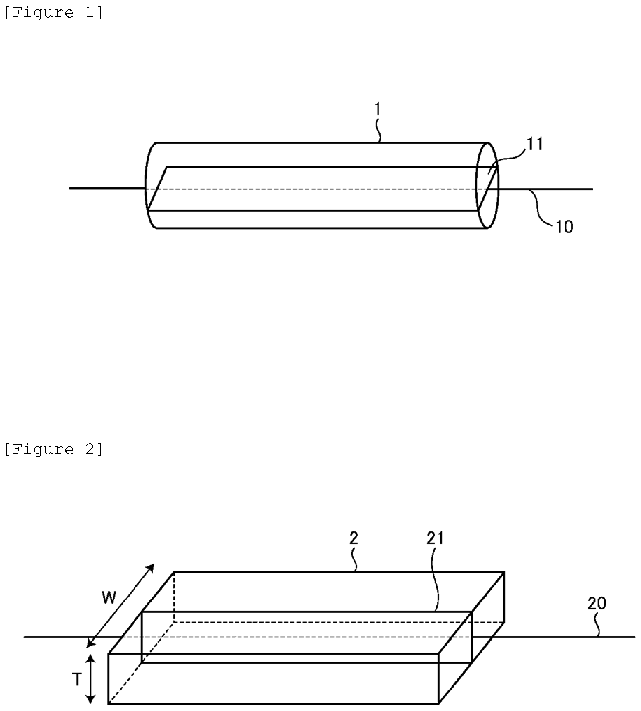

That is, the center axis of the Al bonding wire and the cross section in the center axis direction including the center axis (L cross-section) are as illustrated in FIG. 1. FIG. 1 illustrates a case of the Al bonding wire having a circular cross-sectional shape. In a case of the Al bonding ribbon having a rectangular or substantially rectangular cross-sectional shape with a width W and a thickness T, the center axis indicates an axis passing through the center of the width W and the center of the thickness T, and the L cross-section indicates a cross section in the center axis direction including the center axis and perpendicular to the width W direction (FIG. 2). Specifically, the center axis of the Al bonding ribbon and the cross section in the center axis direction including the center axis (L cross-section) are as illustrated in FIG. 2. When cross-sectional processing is performed to expose the L cross-section of the Al bonding wire, it may be deviated from the center axis of the Al bonding wire. At this point, if the length of the L cross-section in the direction perpendicular to the center axis is 90% or more of a wire diameter of the Al bonding wire, the cross section can be regarded as a cross section including the center axis.

A reason why the Al bonding wire or the Al bonding ribbon according to the present invention exhibits an excellent shear force ratio is estimated as follows.

The present inventors have found that voids having a size in order of several micrometers are present in the Al-Si alloy wire or ribbon, and that the voids are mainly formed around the Si phase. This is considered to be because voids are formed inside during a wire-drawing step for the Al-Si alloy wire or a rolling step for the Al-Si alloy ribbon. At the wire-drawing step or the rolling step, deformation of the hard Si phase is suppressed, whereas the Al phase around the Si phase is plastically deformed easily, so that voids are considered to be formed at an end part of the Si phase. Also, the voids being minute and the total volume fraction of the minute voids being low are considered to act advantageously for relieving the compressive deformation due to load application at the time of bonding and for achieving uniform deformation through local dispersion of ultrasonic vibrations.

In the present invention, the volume ratio of voids having a minute size and the number distribution of the equivalent circle diameter of the Si phase are mutually involved, whereby an effect of improving the bonding interface is further enhanced, and the shear force ratio can be increased. By setting the minute void volume ratio [Vs/Vc × 100 (%)] within a range equal to or larger than 0.02% and equal to or smaller than 4.00%, an effect of reducing crack generation under the bonding part can be utilized due to an action of relieving compressive stress and propagation of ultrasonic vibrations. It is also considered that, by satisfying the number distribution of the Si phase having a small equivalent circle diameter at the same time, local concentration of distortion in a vicinity of the bonding interface is relieved, and metallic bonding at the bonding interface can be accelerated.

There is a concern that stress and distortion may concentrate, or a crack may be generated with the Si phase serving as a starting point around the Si phase having a large equivalent circle diameter. On the other hand, by using the Si phase having a small equivalent circle diameter, stress concentration and distortion in the vicinity of the bonding interface can be relatively uniformly relieved. Accordingly, by controlling the number distribution of the Si phases having a small equivalent circle diameter accounting for a total number of the Si phases, the shear force ratio can be increased.

### -Si concentration-

A Si concentration in a range equal to or larger than 3.0% by mass and equal to or smaller than 20.0% by mass is useful in improving the shear force ratio, and in reducing thermal distortion of the bonding part to improve temperature cycle reliability. Specifically, when the Si concentration is equal to or larger than 3.0% by mass, an improvement effect in temperature cycle reliability can be increased. In addition, regarding an upper limit of the Si concentration, along with progress and optimization of equipment and conditions used for manufacturing and bonding of a wire or the like, higher values have become allowable while suppressing defects such as wire breakage during processing, deterioration of surface properties, reduction in initial bonding strength due to hardening, and damage to the semiconductor chip; however, when the Si concentration is equal to or smaller than 20.0% by mass, these defects can be favorably suppressed while improving the shear force ratio. From a viewpoint of obtaining favorable temperature cycle reliability, the concentration of Si in the Al bonding wire or the Al bonding ribbon according to the present invention is equal to or larger than 3.0% by mass, preferably equal to or larger than 3.5% by mass, more preferably equal to or larger than 4.0% by mass, even more preferably equal to or larger than 4.2% by mass, equal to or larger than 4.4% by mass, equal to or larger than 4.5% by mass, equal to or larger than 4.6% by mass, equal to or larger than 4.8% by mass, or equal to or larger than 5.0% by mass. In addition, from a viewpoint of improving the shear force ratio while favorably suppressing defects such as reduction in initial bonding strength due to hardening and damage to the semiconductor chip, the concentration of Si in the Al bonding wire or the Al bonding ribbon according to the present invention is equal to or smaller than 20.0% by mass, and preferably equal to or smaller than 19.0% by mass, equal to or smaller than 18.0% by mass, equal to or smaller than 17.0% by mass, equal to or smaller than 16.0% by mass, equal to or smaller than 15.0% by mass, equal to or smaller than 14.5% by mass, equal to or smaller than 14.0% by mass, equal to or smaller than 13.5% by mass, equal to or smaller than 13.0% by mass, or equal to or smaller than 12.5% by mass. Furthermore, when hardness of the Al bonding wire or the Al bonding ribbon is high, the semiconductor chip tends to be easily damaged at the time of 1st bonding depending on bonding conditions of ultrasonic vibrations and loads. From a viewpoint of obtaining favorable bonding strength under a wider range of bonding conditions, the Si concentration in the Al bonding wire or the Al bonding ribbon according to the present invention is more preferably equal to or smaller than 12.0% by mass, still more preferably equal to or smaller than 11.5% by mass or equal to or smaller than 11.0% by mass, and particularly preferably equal to or smaller than 10.8% by mass, equal to or smaller than 10.6% by mass, equal to or smaller than 10.5% by mass, equal to or smaller than 10.4% by mass, equal to or smaller than 10.2% by mass, or equal to or smaller than 10.0% by mass.

For concentration analysis of elements contained in the Al bonding wire or the Al bonding ribbon according to the present invention, for example, an Inductively Coupled Plasma (ICP) emission spectrophotometer or an ICP mass spectrometer can be used. In a case in which elements derived from contaminants in the air, such as oxygen or carbon, are adsorbed on a surface of the Al bonding wire or the Al bonding ribbon, it is effective to clean it with acid or alkali depending on adsorbed substances before performing analysis.

### -Minute void volume ratio-

In a region observed by X-ray Computed Tomograpy (CT) analysis, when a total volume of voids having an equivalent sphere diameter equal to or larger than 1 µm and smaller than 10 µm is defined as Vs and a total volume of a measurement region is defined as Vc, by controlling a ratio of Vs to Vc [Vs/Vc × 100 (%)] to fall within an appropriate range and controlling a distribution of the equivalent circle diameter of the Si phase (described later) to fall within an appropriate range, metallic bonding at the bonding interface can be accelerated, and as a result, the shear force ratio can be increased and temperature cycle test reliability can be improved.

The present inventors have confirmed that a volume of relatively small voids having an equivalent sphere diameter in a range equal to or larger than 1 µm and smaller than 10 µm contributes to improvement of the bonding property. A lower limit is set to 1 µm in consideration of the fact that an effect of relieving distortion can be sufficiently obtained when the equivalent sphere diameter of the void is equal to or larger than 1 µm, a constraint of spatial resolution of X-ray CT analysis, and the like. Regarding an upper limit of the equivalent sphere diameter of the void, the upper limit is set to 10 µm in comprehensive consideration of the fact that a sufficient improvement effect can be obtained by setting the upper limit to be smaller than 10 µm, and that it is advantageous for production by wire-drawing processing or a rolling step.

The reason why the shear force ratio is improved at the case that the minute void volume ratio [Vs/Vc × 100 (%)] is equal to or larger than 0.02% and equal to or smaller than 4.00% is estimated as follows. By setting the minute void volume ratio to be equal to or larger than 0.02%, an effect of relieving distortion by the voids can be sufficiently increased, and therefore an effect of increasing the shear force ratio can be sufficiently obtained. On the other hand, regarding an upper limit, by setting the minute void volume ratio to be equal to or smaller than 4.00%, it is possible to prevent the Si phase from being hindered in an action of reducing thermal expansion. That is, by controlling the minute void volume ratio to fall within a range equal to or larger than 0.02% and equal to or smaller than 4.00%, it is possible to adapt to bonding of a thin power semiconductor or a power semiconductor having an element arranged directly below an electrode.

From a viewpoint of further improving the shear force ratio, a lower limit of the minute void volume ratio [Vs/Vc × 100 (%)] of the Al bonding wire or the Al bonding ribbon is equal to or larger than 0.02%, preferably equal to or larger than 0.03% or equal to or larger than 0.05%, more preferably equal to or larger than 0.08% or equal to or larger than 0.10%, still more preferably equal to or larger than 0.20% or equal to or larger than 0.30%, and particularly preferably equal to or larger than 0.50%, equal to or larger than 0.80%, or equal to or larger than 1.00%. From a viewpoint of further improving the shear force ratio, an upper limit of the minute void volume ratio [Vs/Vc × 100 (%)] of the Al bonding wire or the Al bonding ribbon is equal to or smaller than 4.00%, preferably equal to or smaller than 3.80% or equal to or smaller than 3.60%, more preferably equal to or smaller than 3.40% or equal to or smaller than 3.20%, still more preferably equal to or smaller than 3.00%, equal to or smaller than 2.80%, or equal to or smaller than 2.60%, and particularly preferably equal to or smaller than 2.40%, equal to or smaller than 2.20%, or equal to or smaller than 2.00%.

### -Distribution of equivalent circle diameter of Si phase in L cross-section-

From a viewpoint of further improving the shear force ratio, when the number of the Si phases having an equivalent circle diameter equal to or larger than 0.5 µm and equal to or smaller than 0.8 µm in the L cross-section of the Al bonding wire or the Al bonding ribbon is defined as Ns, and the number of the Si phases having an equivalent circle diameter equal to or larger than 0.5 µm in the L cross-section is defined as Nc, a ratio of Ns to Nc [Ns/Nc × 100 (%)] (hereinafter, also referred to as a "small-diameter ratio of the Si phase") is equal to or larger than 30% and equal to or smaller than 95%. A lower limit of the small-diameter ratio [Ns/Nc × 100 (%)] of the Si phase is preferably equal to or larger than 32%, equal to or larger than 35%, equal to or larger than 38%, equal to or larger than 40%, equal to or larger than 42%, or equal to or larger than 45%, more preferably equal to or larger than 48%, still more preferably equal to or larger than 50% or equal to or larger than 52%, and particularly preferably equal to or larger than 55% or equal to or larger than 60%. An upper limit of the small-diameter ratio [Ns/Nc × 100 (%)] of the Si phase is preferably equal to or smaller than 92%, equal to or smaller than 90%, equal to or smaller than 88%, or equal to or smaller than 85%, more preferably equal to or smaller than 82% or equal to or smaller than 80%, still more preferably equal to or smaller than 78% or equal to or smaller than 75%, and particularly preferably equal to or smaller than 72% or equal to or smaller than 70%. In one embodiment, the small-diameter ratio [Ns/Nc × 100 (%)] of the Si phase is preferably equal to or larger than 40% and equal to or smaller than 90%.

A reason why the ratio of the Si phases having an equivalent circle diameter equal to or larger than 0.5 µm and equal to or smaller than 0.8 µm is important is considered as follows. That is, since the Si phase having an equivalent circle diameter equal to or larger than 0.5 µm has a sufficiently large volume, an action of reducing thermal expansion can be sufficiently obtained. It is also appropriate to target the Si phase having an equivalent circle diameter equal to or larger than 0.5 µm from a viewpoint of analysis accuracy of current analysis apparatuses of EDS and EBSD. On the other hand, in the Si phase having an equivalent circle diameter equal to or smaller than 0.8 µm, stress and distortion in the vicinity of the bonding interface due to the Si phase become sufficiently uniform. A reason why the shear force ratio can be further improved when the range of the small-diameter ratio [Ns/Nc × 100 (%)] of the Si phase is equal to or larger than 30% and equal to or smaller than 95% is considered as follows. That is, by setting the small-diameter ratio of the Si phase to be equal to or larger than 30%, it is possible to suppress an increase in the ratio of Si phases having a coarse equivalent circle diameter, and transmission of ultrasonic vibrations is less likely to be inhibited, so that metallic bonding at the interface can be strengthened. On the other hand, by setting the small-diameter ratio of the Si phase to be equal to or smaller than 95%, it is possible to prevent an increase in resistance to plastic deformation due to fine Si, and to reduce a risk of damaging an element directly below the electrode.

Herein, each Si phase is formed in a particulate shape, and it has been confirmed that the number of particles of the Si phase has a large influence on distortion at the bonding interface. Accordingly, the ratio of the number of particles of the Si phase influences the shear force ratio. On the other hand, when areas of the particles are used, an influence of coarse particles is overestimated, so that it is difficult to accurately evaluate correlation with the shear force ratio.

### -Minute void number ratio-

In addition to the control of the minute void volume ratio [Vs/Vc × 100 (%)] described above, in a region observed by X-ray CT analysis, when a total number of voids having an equivalent sphere diameter equal to or larger than 1 µm and smaller than 7 µm is defined as Ps, and a total number of voids having an equivalent sphere diameter equal to or larger than 1 µm is defined as Pc, a ratio of Ps to Pc [Ps/Pc × 100 (%)] (hereinafter, referred to as a "minute void number ratio") being equal to or larger than 60% and equal to or smaller than 98% makes it possible to enhance an effect of achieving both increasing the shear force ratio and reducing chip damage directly below the bonding.

By appropriately controlling the minute void number ratio [Ps/Pc × 100 (%)] that is a ratio of the number of fine voids having an equivalent sphere diameter equal to or larger than 1 µm and smaller than 7 µm, it is possible to enhance actions of propagating ultrasonic vibrations and uniformizing distortion in the vicinity of the bonding interface. Since coarse voids have a small improvement effect, increasing the minute void number ratio, which is a ratio of the number of fine voids to the total number of voids, while managing the void volume ratio accelerates deformation of the 1st bonding and accelerates increasing the shear force ratio. As an influence thereof, it becomes possible to adjust a load and an ultrasonic output, and an improvement effect of reducing chip damage directly below the bonding can be obtained. For example, it is also advantageous to reduce damage to a semiconductor at the time of bonding by using a bonding condition in which an ultrasonic output is set to be high at an initial stage and is gradually decreased (hereinafter, referred to as an "inclined bonding condition"). Due to a synergistic effect of controlling the minute void number ratio and the small-diameter ratio of Si at the same time, it is possible to expand a margin of the bonding condition in a thin power semiconductor or a power semiconductor in which an element is arranged directly below an electrode, and to obtain good bonding even under the inclined bonding condition.

A reason why the number of fine voids having an equivalent sphere diameter in a range equal to or larger than 1 µm and smaller than 7 µm is important is that it has been confirmed, by statistical analysis of experimental data, that an effect of relieving distortion is sufficiently large when a void size is equal to or larger than 1 µm as described above, and an improvement effect is sufficiently large when the void size is smaller than 7 µm. A reason why the minute void number ratio [Ps/Pc × 100 (%)] is preferably equal to or larger than 60% and equal to or smaller than 98% is considered as follows. When the minute void number ratio is equal to or larger than 60%, an effect of relieving distortion by the voids can be sufficiently obtained, so that an effect of increasing the shear force ratio under the inclined bonding condition can be sufficiently obtained. On the other hand, when the minute void number ratio is equal to or smaller than 98%, industrial manufacture becomes relatively easy.

From a viewpoint of further increasing the shear force ratio of the inclined bonding condition, a lower limit of the minute void number ratio [Ps/Pc × 100 (%)] is equal to or larger than 60%, preferably equal to or smaller than 62%, more preferably equal to or smaller than 64%, still more preferably equal to or smaller than 66%, and particularly preferably equal to or smaller than 68% or equal to or smaller than 70%. From a viewpoint of further increasing the shear force ratio under the inclined bonding condition, an upper limit of the minute void number ratio [Ps/Pc × 100 (%)] is equal to or smaller than 98%, preferably equal to or smaller than 96%, more preferably equal to or smaller than 94% or equal to or smaller than 92%, still more preferably equal to or smaller than 90% or equal to or smaller than 88%, and particularly preferably equal to or smaller than 86% or equal to or smaller than 84%.

### -Analysis of void by X-ray CT-

In the present invention, the minute void volume ratio [Vs/Vc × 100 (%)] and the minute void number ratio [Ps/Pc × 100 (%)] are measured by using X-ray CT analysis. The X-ray CT analysis technology is excellent in nondestructively observing voids in a substance, and by performing three-dimensional image analysis based on data thereof, minute voids in a metal can be observed with high accuracy. The following exemplifies an analysis method for measuring voids in the Al bonding wire having a wire diameter of 300 µm. An analysis condition and the like are not limited thereto, and an appropriate analysis condition can be selected depending on an apparatus and a sample. As the X-ray CT apparatus, for example, a 3D X-ray microscope "Xradia 520 Versa" (manufactured by ZEISS) can be used. Main measurement conditions in X-ray CT are as follows. An X-ray voltage can be 40 kV, an X-ray output can be 3 W, a wavelength limiting filter can be LE1, and a magnification lens can be 4x. Under the conditions described above, it has been confirmed that a transmission image having a transmittance of 30% to 70% can be obtained. To observe minute voids, by setting a size per pixel to be about 0.7 µm/pixel, a region of about 700 µm × 700 µm × 700 µm can be measured as a measurement field of view. By fixing a sample with a sample length of about 10 mm, a CT projection image can be measured by transmitting X-rays at a rotation angle of 360 degrees about an axis of the sample. After CT projection images at all angles are obtained, reconstruction processing such as center shift processing is performed, whereby three-dimensional image data can be acquired.

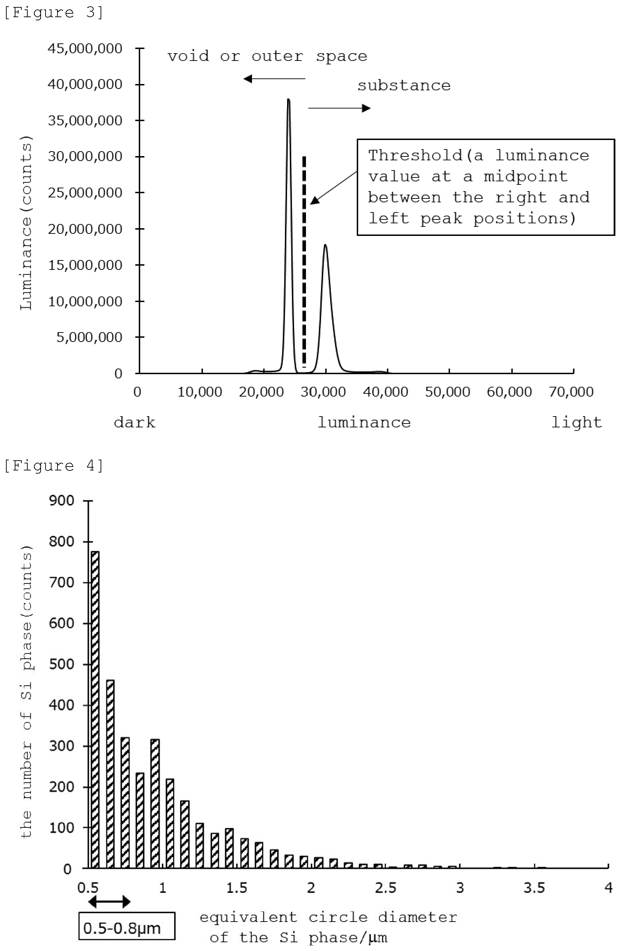

Next, the three-dimensional image data is analyzed by using image analysis software. As the image analysis software, Avizo Inspection can be used. Specifically, a luminance histogram (FIG. 3) is created by using measurement data. A luminance value at a midpoint between two peak positions corresponding to a void or an outer space and a substance is set as a threshold. An image data region showing a luminance lower than the threshold is identified as a void or an outer space (an environment around the sample). Next, with respect to the identified void and outer space, processing of selecting a region of the outer space and removing the region from the image data region is performed. Due to this, image data of only voids in the substance within the measurement region of the sample can be identified. Next, by similar processing, image data having a luminance higher than the threshold is identified as image data relating to the substance. This "substance" has mass and volume, and in the Al bonding wire or the Al bonding ribbon according to the present invention, Al, Si, a first element group, a second element group, and other elements, as well as alloys, oxides, intermetallic compounds, and the like thereof are included. In the X-ray CT analysis of the present invention, a pixel showing a luminance higher than the threshold described above is regarded as having a substance.

Analysis is performed on respective pieces of image data of the voids and the substance obtained as described above. A method for calculating the minute void volume ratio and the minute void number ratio will be specifically described. By using the image analysis software, the total volume Vs of voids having an equivalent sphere diameter equal to or larger than 1 µm and smaller than 10 µm, a total volume (Vg) of voids of all sizes, and a volume (Vm) of the substance are calculated. A value obtained by adding Vg to Vm is calculated as the total volume Vc of the measurement region (Vc = Vg + Vm). The minute void volume ratio [Vs/Vc × 100 (%)], which is a ratio of Vs to Vc, is then obtained. Furthermore, by using the image analysis software, the total number Ps of voids having an equivalent sphere diameter equal to or larger than 1 µm and smaller than 7 µm, and the total number Pc of voids having an equivalent sphere diameter equal to or larger than 1 µm are calculated. The minute void number ratio is calculated as a ratio of Ps to Pc [Ps/Pc × 100 (%)].

### -Method for measuring equivalent circle diameter of Si phase and method for calculating small-diameter ratio-

The following describes a method for measuring the equivalent circle diameter of the Si phase in the L cross-section of the Al bonding wire or the Al bonding ribbon. The equivalent circle diameter of the Si phase in the L cross-section can be measured by using an SEM-EDS-EBSD apparatus. Specifically, a method of combining information of Al concentration and Si concentration obtained by Scanning Electron Microscope-Energy Dispersive X-ray Spectroscopy (SEM-EDS) and information of a crystal orientation obtained by Electron BackScatter Diffraction (EBSD) can be used. More specifically, in a measurement region designating the L cross-section of the Al bonding wire or the Al bonding ribbon to be an inspection surface, measurement of concentration of Al and Si using the EDS and crystal orientation analysis using the EBSD are performed at the same time. Subsequently, the Al phase and the Si phase are separated and extracted from a measurement result of the EDS by using analysis software attached to the apparatus. Specifically, it is preferable to use Chi Scan function, which is a function of analysis software OIM Data Collection or OIM Analysis (both manufactured by TSL solutions KK) attached to a Field Emission-Scanning Electron Microscope (FE-SEM) apparatus. For a region that is specified as the Si phase, a crystal orientation can be analyzed by using the analysis software attached to the apparatus. If an orientation difference between measurement points is equal to or larger than 15°, it is determined to be a crystal grain boundary, and an equivalent circle diameter is calculated. In a process of obtaining the small-diameter ratio of the Si phase, calculation is performed excluding a part in which the crystal orientation cannot be measured, and a part in which the crystal orientation can be measured but reliability of orientation analysis is low. Thus, in one embodiment, the small-diameter ratio of the Si phase in the L cross-section of the Al bonding wire or the Al bonding ribbon according to the present invention is calculated through procedures from (1) to (3) as follows.
(1) The L cross-section of the Al bonding wire or the Al bonding ribbon is designated as the inspection surface, and measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si in a material file.
(3) For the region that is specified as the Si phase, the crystal orientation is analyzed, and if the orientation difference between measurement points is equal to or larger than 15°, it is determined to be the crystal grain boundary, and the equivalent circle diameter of each crystal grain is obtained. The number of crystal grains identified as the Si phase is counted, and a total number Nc of particles of the Si phase is obtained. Herein, the Si phase having an equivalent circle diameter equal to or larger than 0.5 µm is targeted. In consideration of analysis accuracy of current analysis apparatuses of EDS and EBSD, fine ones smaller than 0.5 µm are excluded from the target. In addition, the number Ns of the Si phases having an equivalent circle diameter in a range equal to or larger than 0.5 µm and equal to or smaller than 0.8 µm is counted. The ratio of Ns to Nc [Ns/Nc × 100 (%)] (small-diameter ratio of the Si phase) is then calculated.

In the procedure of (2) described above, setting of Tolerance (%) can be selected in a range from 20 to 40%, and about 30% is preferable for comparison in standard analysis of the L cross-section of the Al bonding wire or the Al bonding ribbon. The procedure of adjusting the Tolerance is described supplementarily. It is preferable to select or confirm a numerical value of Tolerance so that the shape and the size of the Si phase identified from an EDS map in which Si element concentration by EDS analysis is two-dimensionally displayed are equivalent to the shape and the size of the Si phase extracted and identified by the Chi Scan function .

In the present invention, the small-diameter ratio of the Si phase is calculated as an average value (arithmetic mean) of respective values of orientation ratios obtained by measuring at three or more parts. In selecting the measurement region, from a viewpoint of securing objectivity of measurement data, it is preferable to acquire a sample for measurement to be measured from the Al bonding wire or the Al bonding ribbon as a measurement target at intervals of 50 cm or more with respect to the center axis direction of the Al bonding wire or the Al bonding ribbon. Moreover, in the present invention, the measurement region for the crystal orientation measured by the EBSD method is preferably determined so that the length in the center axis direction of the Al bonding wire or the Al bonding ribbon is equal to or larger than 300 µm and smaller than 800 µm and the entire Al bonding wire or the entire Al bonding ribbon is accommodated therein in a direction perpendicular to the center axis of the Al bonding wire or the Al bonding ribbon, but if the size is large and the entire region is difficult to be measured, it can be adjusted in a range smaller than 600 µm.

An example of measurement results is illustrated in FIG. 4. A horizontal axis indicates an equivalent circle diameter of the Si phase, each section is indicated with a width of 0.1 µm, and a vertical axis indicates the number of particles. A range equal to or larger than 0.5 µm and equal to or smaller than 0.8 µm is indicated by a double-headed arrow, and the particle number ratio [Ns/Nc × 100 (%)] in this section is 50%. It has been confirmed that this Al bonding wire exhibits an excellent shear force ratio.

### -Addition of Sr, Na, Dy, and B-

The Al bonding wire or the Al bonding ribbon according to the present invention may further contain one or more of Sr, Na, Dy, and B (hereinafter, also referred to as a "first element group"). A total concentration of the first element group may be 0 mass ppm, preferably equal to or larger than 1 mass ppm, more preferably equal to or larger than 3 mass ppm, still more preferably equal to or larger than 5 mass ppm, and particularly preferably equal to or larger than 8 mass ppm or equal to or larger than 10 mass ppm. An upper limit of the total concentration of the first element group is preferably equal to or smaller than 10000 mass ppm or equal to or smaller than 8000 mass ppm, more preferably equal to or smaller than 5000 mass ppm or equal to or smaller than 3000 mass ppm, still more preferably equal to or smaller than 2000 mass ppm or equal to or smaller than 1000 mass ppm, and particularly preferably equal to or smaller than 900 mass ppm or equal to or smaller than 800 mass ppm. In one embodiment, the total concentration of the first element group is preferably equal to or larger than 10 mass ppm and equal to or smaller than 800 mass ppm.

When the Al bonding wire or the Al bonding ribbon according to the present invention further contains 10 mass ppm or more and 800 mass ppm or less of one or more of Sr, Na, Dy, and B in total, a generation frequency of wire breakage can be reduced in wire-drawing processing for the Al bonding wire or the Al bonding ribbon. In an Al alloy containing a high concentration of Si equal to or larger than 3.0% by mass and equal to or smaller than 20.0% by mass, a frequency of wire breakage at a wire-drawing step tends to be increased. This may be because the particles of the Si phase crystallized at the time of solidification cause stress concentration during the wire-drawing processing and induce wire breakage. It is estimated that stress concentration during wire-drawing can be relieved and wire breakage can be reduced due to effects such that the particulate Si phase may be uniformly distributed, and/or growth and coarsening of the Si phase may be suppressed by adding the first element group. It is considered that an effect of relieving stress concentration during wire-drawing can be enhanced by controlling the minute void volume ratio of the Si phase and the small-diameter ratio of the Si phase and adding the first element group thereto.

From a viewpoint of reducing the generation frequency of wire breakage in the wire-drawing processing, the total concentration of the first element group in the Al bonding wire or the Al bonding ribbon according to the present invention is more preferably equal to or larger than 20 mass ppm, and still more preferably equal to or larger than 30 mass ppm, equal to or larger than 40 mass ppm, or equal to or larger than 50 mass ppm, and an upper limit thereof is preferably equal to or smaller than 750 mass ppm, more preferably equal to or smaller than 740 mass ppm, equal to or smaller than 720 mass ppm, or equal to or smaller than 700 mass ppm, still more preferably equal to or smaller than 680 mass ppm, equal to or smaller than 650 mass ppm, equal to or smaller than 620 mass ppm, or equal to or smaller than 600 mass ppm, and particularly preferably equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains one or more elements of the first element group, it may contain any one element of the first element group, may contain any two elements of the first element group, may contain any three elements of the first element group, or may contain all of four elements of the first element group. Moreover, in a case in which the Al bonding wire or the Al bonding ribbon according to the present invention contains one or more elements of the first element group, it may contain Sr, may contain Na, may contain Dy, and/or may contain B.

In a case in which the Al bonding wire or the Al bonding ribbon according to the present invention contains Sr of the first element group, a concentration of Sr may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Sr is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Sr is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. Moreover, from a viewpoint of reducing the generation frequency of wire breakage in the wire-drawing processing, the concentration of Sr is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains Na of the first element group, a concentration of Na may be 0 mass ppm, and preferably equal to or larger than 1 mass ppm, equal to or larger than 3 mass ppm, equal to or larger than 5 mass ppm, or equal to or larger than 8 mass ppm. Moreover, from a viewpoint of reducing the generation frequency of wire breakage in the wire-drawing processing, the concentration of Na is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Na is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. Moreover, from a viewpoint of reducing the generation frequency of wire breakage in the wire-drawing processing, the concentration of Na is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains Dy of the first element group, a concentration of Dy may be 0 mass ppm, and preferably equal to or larger than 1 mass ppm, equal to or larger than 3 mass ppm, equal to or larger than 5 mass ppm, or equal to or larger than 8 mass ppm. Moreover, from a viewpoint of reducing the generation frequency of wire breakage in the wire-drawing processing, the concentration of Dy is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Dy is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. Moreover, from a viewpoint of reducing the generation frequency of wire breakage in the wire-drawing processing, the concentration of Dy is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains B of the first element group, a concentration of B may be 0 mass ppm, and preferably equal to or larger than 1 mass ppm, equal to or larger than 3 mass ppm, equal to or larger than 5 mass ppm, or equal to or larger than 8 mass ppm. Moreover, from a viewpoint of reducing the generation frequency of wire breakage in the wire-drawing processing, the concentration of B is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of B is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. Moreover, from a viewpoint of reducing the generation frequency of wire breakage in the wire-drawing processing, the concentration of B is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

### -Addition of Ni, Ti, Fe, and Cu-

The Al bonding wire or the Al bonding ribbon according to the present invention may further contain one or more of Ni, Ti, Fe, and Cu (hereinafter, also referred to as a "second element group"). A total concentration of the second element group may be 0 mass ppm, preferably equal to or larger than 1 mass ppm or equal to or larger than 3 mass ppm, more preferably equal to or larger than 5 mass ppm or equal to or larger than 8 mass ppm, still more preferably equal to or larger than 10 mass ppm or equal to or larger than 30 mass ppm, and particularly preferably equal to or larger than 50 mass ppm, equal to or larger than 80 mass ppm, or equal to or larger than 100 mass ppm. An upper limit of the total concentration of the second element group is preferably equal to or smaller than 10000 mass ppm, more preferably equal to or smaller than 8000 mass ppm, still more preferably equal to or smaller than 5000 mass ppm, and particularly preferably equal to or smaller than 3000 mass ppm, equal to or smaller than 2000 mass ppm, equal to or smaller than 1800 mass ppm, equal to or smaller than 1600 mass ppm, or equal to or smaller than 1500 mass ppm. In one embodiment, the total concentration of the second element group is preferably equal to or larger than 100 mass ppm and equal to or smaller than 1500 mass ppm.

When the Al bonding wire or the Al bonding ribbon according to the present invention further contains 100 mass ppm or more and 1500 mass ppm or less of one or more of Ni, Ti, Fe, and Cu in total, generation of scratches and scrapes on the surface of the Al bonding wire or the Al bonding ribbon can be suppressed, and a smooth surface can be formed. In an Al alloy containing a high concentration of Si equal to or larger than 3.0% by mass and equal to or smaller than 20.0% by mass, scratches and scrapes may be generated on a surface thereof during the wire-drawing processing due to surface hardening and the detachment of the Si phases and Al oxides present on the surface. As a result, this can lead to the Al bonding wire or the Al bonding ribbon with large surface unevenness. It is estimated that scratches and scrapes during the wire-drawing processing can be reduced by adding the second element group to accelerate stabilization of the Al oxide on the surface of the Al bonding wire or the Al bonding ribbon, refinement and hardening of structures of Al crystal grains, and the like. It is considered that an effect of suppressing generation of scratches and scrapes on the surface of the Al bonding wire or the Al bonding ribbon to form a smooth surface can be enhanced by controlling the minute void volume ratio of the Si phase and the small-diameter ratio of the Si phase and adding the second element group thereto.

From a viewpoint of suppressing generation of scratches and scrapes on the surface to form the Al bonding wire or the Al bonding ribbon having a smooth surface, the total concentration of the second element group in the Al bonding wire or the Al bonding ribbon according to the present invention is more preferably equal to or larger than 150 mass ppm, and still more preferably equal to or larger than 200 mass ppm, equal to or larger than 250 mass ppm, or equal to or larger than 300 mass ppm, and an upper limit thereof is more preferably equal to or smaller than 1200 mass ppm, still more preferably equal to or smaller than 1000 mass ppm, equal to or smaller than 900 mass ppm, or equal to or smaller than 800 mass ppm, and particularly preferably equal to or smaller than 700 mass ppm, equal to or smaller than 600 mass ppm, or equal to or smaller than 500 mass ppm.

In a case in which the Al bonding wire or the Al bonding ribbon according to the present invention contains one or more elements of the second element group, it may contain any one element of the second element group, may contain any two elements of the second element group, may contain any three elements of the second element group, or may contain all of four elements of the second element group. In a case in which the Al bonding wire or the Al bonding ribbon according to the present invention contains one or more elements of the second element group, it may contain Ni, may contain Ti, may contain Fe, and/or may contain Cu.

In a case in which the Al bonding wire or the Al bonding ribbon according to the present invention contains Ni of the second element group, a concentration of Ni may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Ni is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Ni is preferably equal to or smaller than 10000 mass ppm, equal to or smaller than 8000 mass ppm, equal to or smaller than 5000 mass ppm, or equal to or smaller than 3000 mass ppm. Moreover, from a viewpoint of suppressing generation of scratches and scrapes on the surface to form the Al bonding wire or the Al bonding ribbon having a smooth surface, the concentration of Ni is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Ti of the second element group, a concentration of Ti may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. Moreover, from a viewpoint of suppressing generation of scratches and scrapes on the surface to form the Al bonding wire or the Al bonding ribbon having a smooth surface, the concentration of Ti is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Ti is preferably equal to or smaller than 10000 mass ppm, equal to or smaller than 8000 mass ppm, equal to or smaller than 5000 mass ppm, or equal to or smaller than 3000 mass ppm. Moreover, from a viewpoint of suppressing generation of scratches and scrapes on the surface to form the Al bonding wire or the Al bonding ribbon having a smooth surface, the concentration of Ti is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Fe of the second element group, a concentration of Fe may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Fe is more preferably equal to or larger than 100 mass ppm, and still more preferably equal to or larger than 150 mass ppm, equal to or larger than 200 mass ppm, equal to or larger than 250 mass ppm, or equal to 300 mass ppm. An upper limit of the concentration of Fe is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Fe is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Cu of the second element group, a concentration of Cu may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. Moreover, from a viewpoint of suppressing generation of scratches and scrapes on the surface to form the Al bonding wire or the Al bonding ribbon having a smooth surface, the concentration of Cu is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Cu is preferably equal to or smaller than 10000 mass ppm, equal to or smaller than 8000 mass ppm, equal to or smaller than 5000 mass ppm, or equal to or smaller than 3000 mass ppm. Moreover, from a viewpoint of suppressing generation of scratches and scrapes on the surface to form the Al bonding wire or the Al bonding ribbon having a smooth surface, the concentration of Cu is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

As an aluminum raw material for manufacturing the Al bonding wire or the Al bonding ribbon according to the present invention, it is preferable to use Al having a purity of 4N (Al: 99.99% by mass or more), and more preferable to use Al having a purity of 5N (Al: 99.999% by mass or more) in which an amount of impurities is smaller. In one embodiment, Al having a purity of 3N (Al: 99.9 % by mass or more) may be used.

In a range of not inhibiting the effect of the present invention, the Al bonding wire or the Al bonding ribbon according to the present invention may further contain elements other than Al, Si, the first element group, and the second element group (hereinafter, also referred to as "other elements"). That is, the "other elements" mean elements other than Al, Si, Sr, Na, Dy, B, Ni, Ti, Fe and Cu, and the Al bonding wire or the Al bonding ribbon according to the present invention may further contain elements other than Al, Si, Sr, Na, Dy, B, Ni, Ti, Fe and Cu. A total concentration of the other elements in the Al bonding wire or the Al bonding ribbon is not particularly limited in a range of not inhibiting the effect of the present invention. The total concentration of the other elements may be, for example, equal to or smaller than 0.5% by mass, equal to or smaller than 0.4% by mass, equal to or smaller than 0.3% by mass, equal to or smaller than 0.2% by mass, equal to or smaller than 0.15% by mass, equal to or smaller than 0.1% by mass, equal to or smaller than 0.08% by mass, equal to or smaller than 0.06% by mass, equal to or smaller than 0.05% by mass, equal to or smaller than 0.04% by mass, equal to or smaller than 0.03% by mass, equal to or smaller than 0.025% by mass, equal to or smaller than 0.02% by mass, equal to or smaller than 0.018% by mass, equal to or smaller than 0.016% by mass, equal to or smaller than 0.015% by mass, equal to or smaller than 0.014% by mass, equal to or smaller than 0.012% by mass, or equal to or smaller than 0.01% by mass. A lower limit of the total concentration of the other elements is not particularly limited, and may be 0% by mass.

According to one embodiment, a balance of the Al bonding wire or the Al bonding ribbon according to the present invention consists of Al and the other elements. Thus, according to a preferred embodiment, the Al bonding wire or the Al bonding ribbon according to the present invention consists of Al, Si, and the other elements. According to another preferred embodiment, the Al bonding wire or the Al bonding ribbon according to the present invention consists of Al, Si, one or more elements of the first element group, and the other elements. According to yet another preferred embodiment, the Al bonding wire or the Al bonding ribbon according to the present invention consists of Al, Si, one or more elements of the second element group, and the other elements. According to yet another preferred embodiment, the Al bonding wire or the Al bonding ribbon according to the present invention consists of Al, Si, one or more elements of the first element group, one or more elements of the second element group, and the other elements.

According to one embodiment, a balance of the Al bonding wire or the Al bonding ribbon according to the present invention consists of Al and inevitable impurities. Thus, according to a preferred embodiment, the Al bonding wire or the Al bonding ribbon according to the present invention consists of Al, Si, and inevitable impurities. According to another preferred embodiment, the Al bonding wire or the Al bonding ribbon according to the present invention consists of Al, Si, one or more elements of the first element group, and inevitable impurities. According to yet another preferred embodiment, the Al bonding wire or the Al bonding ribbon according to the present invention consists of Al, Si, one or more elements of the second element group, and inevitable impurities. According to yet another preferred embodiment, the Al bonding wire or the Al bonding ribbon according to the present invention consists of Al, Si, one or more elements of the first element group, one or more elements of the second element group, and inevitable impurities.

According to a preferred embodiment, the Al bonding wire or the Al bonding ribbon according to the present invention does not have a coating that contains a metal other than Al as a main component on an outer periphery of the Al bonding wire or the Al bonding ribbon. Herein, the "coating that contains a metal other than Al as a main component" means the coating in which the content of the metal other than Al is 50% by mass or more.

The Al bonding wire or the Al bonding ribbon according to the present invention may be an Al bonding wire or an Al bonding ribbon. In a case in which the present invention is the Al bonding wire, a wire diameter thereof is not particularly limited, and may be equal to or larger than 50 µm, equal to or larger than 60 µm, equal to or larger than 80 µm, equal to or larger than 100 µm, equal to or larger than 120 µm, equal to or larger than 140 µm, equal to or larger than 150 µm, equal to or larger than 180 µm, or equal to or larger than 200 µm, for example. An upper limit of the wire diameter is not particularly limited, and may be equal to or smaller than 600 µm, equal to or smaller than 550 µm, equal to or smaller than 500 µm, equal to or smaller than 450 µm, or equal to or smaller than 400 µm, for example. In one embodiment, the wire diameter of the Al bonding wire according to the present invention may fall within a range from 100 to 600 µm, and preferably falls within a range from 200 to 400 µm. In a case in which the present invention is the Al bonding ribbon, dimensions (width W × thickness T) of a cross section having a rectangular shape or a substantially rectangular shape are not particularly limited, for example, W may be 100 to 3000 µm and T may be 50 to 600 µm.

The Al bonding wire or the Al bonding ribbon according to the present invention can exhibit an excellent shear force ratio, and can eventually exhibit excellent temperature cycle reliability. Thus, the Al bonding wire or the Al bonding ribbon according to the present invention can be preferably used as an Al bonding wire or an Al bonding ribbon for a semiconductor device. Particularly, the Al bonding wire or the Al bonding ribbon according to the present invention can be preferably used as an Al bonding wire or an Al bonding ribbon for a power semiconductor device, can be more preferably used as an Al bonding wire or an Al bonding ribbon for a SiC power semiconductor device, and can be still more preferably used as an Al bonding wire or an Al bonding ribbon for a power semiconductor device having a thin structure or having an element arranged directly below an electrode.

### -Method for manufacturing Al bonding wire or Al bonding ribbon-

An example of a method for manufacturing the Al bonding wire or the Al bonding ribbon according to the present invention is described. The following describes an example of manufacture of the Al bonding wire.

Al and alloy elements as raw materials preferably have a high purity. Al preferably has a purity of 99.5 % by mass or more and includes inevitable impurities as a balance, more preferably has a purity of 99.9 % by mass or more and includes inevitable impurities as a balance, and still more preferably has a purity of 99.99 % by mass or more and includes inevitable impurities as a balance. Si, the first element group, the second element group, and the other elements used as alloy elements preferably have a purity of 99.9% by mass or more and include inevitable impurities as a balance, and more preferably have a purity of 99.99 % by mass or more and include inevitable impurities as a balance. In a casting process for melting and solidifying an Al alloy used for the Al bonding wire, continuous casting can be used. In continuous casting, while a molten liquid obtained by melting an Al raw material and raw materials of alloy elements is cast into a water-cooled mold, a casting material (ingot) is continuously drawn out from a lower side of the mold. An atmosphere in the furnace at the time of melting is preferably an inert atmosphere or a reducing atmosphere to prevent Al, Si, the first element group, the second element group, and the other elements constituting the wire or the ribbon from being excessively oxidized. The highest endpoint temperature of melted metal at the time of melting preferably falls within a range equal to or higher than 700°C and lower than 1000°C, considering to facilitate control of the shape and the size of the Si phase at the time of solidification and the like while securing fluidity of the melted metal.

The ingot obtained by melting is processed to a wire diameter of 5 to 15 mm by hot extrusion. Furthermore, by performing solution treatment to perform heating at a high temperature, and repeatedly performing wire-drawing processing using dies thereafter, the wire having a desired wire diameter can be manufactured. The wire after being subjected to the wire-drawing processing can be used as an Al bonding wire by performing final heat treatment using the electric furnace. At the hot extrusion step herein, it is necessary to process the sample in a high-temperature state. As a method therefor, for example, it is possible to use a method of taking out the sample heated in the furnace and extruding the sample, or a method of performing extrusion in a state where an apparatus, a jig, and the like are heated.

To control the minute void volume ratio [Vs/Vc × 100 (%)], the minute void number ratio [Ps/Pc × 100 (%)], and the small-diameter ratio of the Si phase, it is effective to control a heat treatment condition for solution treatment, homogenization processing, or final heat treatment, and a wire-drawing processing condition, and the like. At the time of wire-drawing processing, it is effective to use a lubricating liquid to secure lubricity at a contact interface between the wire and the die.

The following describes an example of manufacturing conditions for controlling the minute void volume ratio [Vs/Vc × 100 (%)] to fall within a range equal to or larger than 0.02% and equal to or smaller than 4.00%, and controlling the small-diameter ratio of the Si phase to be equal to or larger than 30% and equal to or smaller than 95%.

### <Control of minute void volume ratio>

To control a volume ratio of voids having an equivalent sphere diameter equal to or larger than 1 µm and smaller than 10 µm, it is advantageous to adjust a generation frequency and growth of voids around the Si phase, which is a main factor of generation of the voids. Processing a solidified casting by hot extrusion, increasing a wire-drawing speed at a wire-drawing step after intermediate annealing, and the like are effective for controlling a generation frequency and a size of voids by utilizing a difference in processing /deformation performance between the Al phase and the Si phase. Furthermore, by treating a cooling process after heat treatment such as solution treatment, intermediate annealing, and final diameter heating by air cooling or water cooling, it is effective for controlling a generation frequency and a size of voids by efficiently utilizing a difference in thermal expansion between the Al phase and the Si phase. When reducing a volume of voids, air cooling is performed, and when increasing the voids, water cooling can be used.

A specific example of the manufacturing condition is described. In hot extrusion, it is desirable to start from an ingot having a wire diameter of 100 to 200 mm and process the ingot to a diameter of 5 to 15 mm. A temperature is set to fall within a range from 250 to 400°C. Such conditions for hot extrusion are advantageous for processing in which deformation resistance of a material is reduced by high-temperature processing and coarsening of voids is suppressed. Furthermore, at a step of performing wire-drawing processing at a wire diameter between a wire diameter at which intermediate annealing is performed and 1/3 of a wire diameter at which wire-drawing is started, it is preferable that an average of the wire-drawing speed is equal to or higher than 20 m/min and lower than 50 m/min. By increasing the wire-drawing speed in a state where processing distortion is reduced by intermediate annealing, it is possible to adjust a volume of small voids without excessively increasing voids by homogenizing distortion in the sample and adjusting a deformation difference between the Al phase and the Si phase.

Solution treatment is performed at a temperature equal to or higher than 450°C and lower than 560°C for a time equal to or longer than 2 hours and shorter than 8 hours, and air cooling is used for cooling. This is because shapes and sizes of voids can be adjusted in a process in which coarse Si phases formed by a eutectic reaction are fragmented and become smaller by solution treatment. Intermediate annealing is performed twice and final diameter annealing is performed once, the temperature is set within a range of 250 to 350°C and the time is set within a range of 1 to 12 hours, and cooling in each case is performed by air cooling. It is preferable that intermediate annealing is performed at a wire diameter in the vicinity of 1/3 and 2/3 of the wire diameter at which wire-drawing is started.

### <Control of minute void number ratio>

For a method for controlling the minute void number ratio, manufacturing conditions substantially the same as those for the method for controlling the void volume ratio described above can be used. Furthermore, to control a number ratio of voids having an equivalent sphere diameter equal to or larger than 1 µm and smaller than 7 µm, it is effective to adjust a thermal history at a solidification step and processing conditions such as hot extrusion and fine wire processing. Specifically, regarding a cooling step in continuous casting, water cooling in which water is sprayed onto the casting material drawn out from the mold is effective. By this water cooling at the time of solidification, it is possible to suppress formation of coarse voids by increasing a generation frequency of voids due to a difference in thermal expansion between Al and Si and suppressing plate-like growth of the Si phase to fragment the Si phase into particulate shape. In addition, it is effective to adjust a generation frequency of fine voids by increasing a degree of processing (area reduction ratio) in one pass of a hot extrusion step.

### <Control of small-diameter ratio of Si phase>

Optimizing an intermediate heat treatment condition and a final heat treatment condition as a set is effective for controlling the small-diameter ratio of the Si phase. Specifically, when a temperature of the intermediate heat treatment at a wire diameter (final) closest to the final wire diameter is defined as Tm (°C) and a temperature of the final heat treatment at the final wire diameter is defined as Tc (°C), if the temperature Tm of the intermediate heat treatment is higher than the temperature Tc of the final heat treatment by 50°C or more, it becomes easy to adjust the small-diameter ratio of the Si phase to be equal to or larger than 30% and equal to or smaller than 95%. Specifically, by increasing the intermediate heat treatment temperature, Si dissolved in the Al phase as a solid solution can be homogenized, and by decreasing the temperature of the final heat treatment step, a solid-solution concentration of Si in the Al phase can be reduced. By a combination of these temperatures, the number of minute Si phases can be increased, and the small-diameter ratio of the Si phase can be increased. Among a plurality of intermediate heat treatments, adjusting the temperature of the last intermediate heat treatment is more effective, and it is considered that increasing the number of minute Si phases can be promoted by utilizing dislocations and the like increased at a subsequent processing step.

As the final heat treatment condition, it is effective to adjust a temperature range to be equal to or higher than 200°C and lower than 360°C, and adjust a time within a range equal to or longer than 2 hours and shorter than 20 hours. By the final heat treatment, recovery and recrystallization of the Al phase proceed, and at the same time, an amount of Si dissolved in the Al phase as a solid solution is changed depending on a heat treatment temperature, whereby a recrystallization temperature is changed. By adjusting progress of recrystallization by the final heat treatment, the small-diameter ratio of the Si phase can be easily controlled. For example, by adjusting the final heat treatment to be performed at a low temperature or in a short time, the small-diameter ratio of the Si phase tends to increase.

As a representative example of the Al bonding wire or the Al bonding ribbon, the example of manufacture of the Al bonding wire as a wire material has been described above. The Al bonding ribbon as a bar material can also be manufactured basically through the same procedure. As the temperature and the time for the heat treatment, substantially the same conditions as described above can be used. In a case of manufacturing the Al bonding ribbon by rolling processing, an area reduction ratio of a die may be replaced with a rolling reduction ratio to be adjusted.

### [Semiconductor device]

The semiconductor device can be manufactured by connecting the electrode on the semiconductor chip to the lead frame or an external electrode on the substrate by using the Al bonding wire or the Al bonding ribbon according to the present invention. That is, the semiconductor device according to the present invention includes the Al bonding wire or the Al bonding ribbon according to the present invention. As described above, wedge bonding is used for both of the 1st bonding with the electrode on the semiconductor chip and the 2nd bonding with the lead frame or the electrode on the substrate.

In one embodiment, the semiconductor device according to the present invention includes a circuit board, the semiconductor chip, and the Al bonding wire or the Al bonding ribbon for bringing the circuit board and the semiconductor chip into conduction with each other, and is characterized in that the Al bonding wire or the Al bonding ribbon is the Al bonding wire or the Al bonding ribbon according to the present invention.

In the semiconductor device according to the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in Japanese Patent Application Laid-open No. 2020-150116, the semiconductor device may include a lead frame and a semiconductor chip mounted on the lead frame.

Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

### [Examples]

Hereinafter, the present invention will be described in detail with reference to Examples. However, the present invention is not limited to the following Examples.

### (Sample)

A method for producing a sample will be described. As a raw material, Al having a purity of 4N (99.99% by mass or more) and including inevitable impurities as a balance was used. Si, the first element group (Sr, Na, Dy, B), the second element group (Ni, Ti, Fe, Cu), and the other elements (Mn, Zn) used as alloy elements each having a purity of 99.99% by mass or more and including inevitable impurities as a balance were also used. The Al alloy used for the Al bonding wire or the Al bonding ribbon was manufactured by loading an Al raw material and raw materials for the alloy elements into a melting crucible, and manufacturing a casting using a continuous casting furnace. An atmosphere inside the furnace at the time of melting was an Ar atmosphere, and the highest end-point temperature of melted metal at the time of melting was set to be equal to or higher than 700°C and lower than 1000°C. A casting material coming out from a mold was solidified while being water-cooled by spraying water.

A cylindrical ingot was obtained by melting, and hot extrusion was performed on the ingot. Subsequently, after solution treatment and homogenization processing were performed, wire-drawing processing using dies and intermediate heat treatment were performed to produce an Al bonding wire of Φ300 µm. By using the Al bonding wire of Φ300 µm as a starting material, an Al bonding ribbon having a thickness of 100 µm and a width of 600 µm was manufactured by two-stage rolling. A temperature range for the solution treatment was set to be equal to or higher than 500°C and lower than 560°C, and a time therefor was set to be equal to or longer than 2 hours and shorter than 4 hours. Homogenization processing was successively performed in the intermediate of cooling after the solution treatment was ended. A temperature range for the homogenization processing was set to be equal to or higher than 250°C and lower than 350°C, and a time therefor was set to be equal to or longer than 2 hours and shorter than 5 hours. The cooling method after the homogenization processing was air cooling for performing cooling in the air.

Hot extrusion was performed until a wire diameter of 10 mm was obtained, and the temperature was set within a range of 250 to 400°C. After the processing to reach the wire diameter of 10 mm by hot extrusion, wire-drawing processing using a die was performed. An area reduction ratio of the wire per die at the time of the wire-drawing processing was equal to or larger than 10.0% and smaller than 30.0%. The area reduction ratio of the wire was adjusted in accordance with a wire diameter of the die. The number of times of the intermediate heat treatment was set to be two, and the wire diameter for the intermediate heat treatment with respect to the wire diameter of 10 mm at which the wire-drawing was started was set to be 5.5 to 7.5 mm for the first intermediate annealing, and set to be 1.5 to 3.0 mm for the second intermediate annealing. A temperature range for the intermediate heat treatment was set to be equal to or higher than 250°C and lower than 400°C, and a time therefor was set to be equal to or longer than 1 hour and shorter than 12 hours.

A temperature range for the final heat treatment was set to be equal to or higher than 200°C and lower than 350°C, and a time for the final heat treatment was set to be equal to or longer than 2 hours and shorter than 20 hours. The temperature (Tc) for the final heat treatment was selected in a temperature range 50 to 100°C lower than the temperature (Tm) of the second intermediate annealing described above.

In some examples, the wire-drawing processing was performed using a die having a die angle equal to or larger than 14° and smaller than 18°.

### (Method for measuring element content)

For concentration analysis of elements contained in the Al bonding wire or the Al bonding ribbon, Inductively Coupled Plasma-Optical Emission Spectrometer (ICP-OES) ("PS3520UVDDII" manufactured by Hitachi High-Tech Science Corporation) or Inductively Coupled Plasma-Mass Spectrometer (ICP-MS) ("Agilent 7700x ICP-MS" manufactured by Agilent Technologies, Inc.) was used as an analysis apparatus.

### (X-ray CT analysis)

As an apparatus, a 3D X-ray microscope "Xradia 520 Versa" (manufactured by ZEISS) was used. An X-ray voltage was 40 kV, an X-ray output was 3 W, a wavelength limiting filter was LE1, and a magnification lens was 4x. A transmittance of a cross-sectional image fell within a range from 30% to 70%. By setting a size per pixel to be about 0.7 um/pixel, a region of about 700 µm × 700 µm × 700 µm was measured as a measurement field of view. By fixing the sample with a sample length of about 10 mm, a CT projection image was measured by transmitting X-rays at a rotation angle of 360 degrees about the axis of the sample. In this measurement, CT projection images were acquired at intervals of 0.225°/image with respect to the rotation angle of 360° (1601 images in total). Furthermore, observation was performed with an exposure time of 30 seconds per CT projection image. After CT projection images at all angles were obtained, reconstruction processing such as center shift processing was performed, whereby three-dimensional image data was acquired. In addition, beam hardening processing was performed as needed.

Next, the three-dimensional image data was analyzed by using image analysis software. As the image analysis software, Avizo Inspection was used. The three-dimensional image data reflects a density difference in an observation region as a three-dimensional distribution of luminance values. A relatively high-density wire or ribbon region (substance) has high luminance, and a low-density void or outer space has low luminance. First, a luminance histogram was created by graphing a luminance value in each voxel of the three-dimensional image data and a frequency thereof. A luminance value at a midpoint between two peak positions corresponding to a void or an outer space and a substance was set as a threshold. An image data region showing a luminance lower than the threshold was identified as a void or an outer space. Next, with respect to the identified void and outer space, processing of selecting a region of the outer space and removing the region from the image data region was performed. Due to this, image data of only voids in the substance within the measurement region was extracted. Next, by similar processing, image data having a luminance higher than the threshold was extracted as image data relating to the substance.

Analysis was performed on respective pieces of image data of the voids and the substance obtained as described above. The following describes a method for calculating the minute void volume ratio and the minute void number ratio. By using the image analysis software, the total volume Vs of voids having an equivalent sphere diameter equal to or larger than 1 µm and smaller than 10 µm, the total volume (Vg) of voids of all sizes, and the volume (Vm) of the substance were calculated. A value obtained by adding Vg to Vm was calculated as the total volume Vc of the measurement region (Vc = Vg + Vm). The minute void volume ratio [Vs/Vc × 100 (%)], which is a ratio of Vs to Vc, was then obtained. Furthermore, by using the image analysis software, the total number Ps of voids having an equivalent sphere diameter equal to or larger than 1 µm and smaller than 7 µm, and the total number Pc of voids having an equivalent sphere diameter equal to or larger than 1 µm were calculated. The minute void number ratio was calculated as a ratio of Ps to Pc [Ps/Pc × 100 (%)].

### (Small-diameter ratio [Ns/Nc × 100 (%)] of Si phase)

In measuring the small-diameter ratio [Ns/Nc × 100 (%)] of the Si phase in the L cross-section, the SEM-EDS-EBSD apparatus was used, and a method of combining information of Al concentration and Si concentration obtained by the SEM-EDS and information of a crystal orientation obtained by the EBSD was used. Specifically, measurement was performed in accordance with procedures from (1) to (3) as follows.
(1) In the measurement region designating the L cross-section of the Al bonding wire or the Al bonding ribbon to be the inspection surface, measurement of concentration of Al and Si using the EDS and crystal orientation measurement using the EBSD were performed at the same time.
(2) Al and Si were separated and extracted by using the Chi Scan function as a function of EBSD analysis software. Specifically, Al and Si were separated and identified by setting Tolerance corresponding to a threshold of Si based on a measurement result of the EDS for Si. The crystal information of Al and Si in the material file was used for analyzing the crystal orientation. Herein, a condition for Tolerance was mainly set to be 30%, and adjusted as needed.
(3) For the region that is specified as the Si phase, the crystal orientation was analyzed, and if the orientation difference between measurement points was equal to or larger than 15°, it was determined to be the crystal grain boundary, and the equivalent circle diameter of each crystal grain was obtained. The number of crystal grains identified as the Si phase was counted, and the total number Nc of particles of the Si phase was obtained. Herein, the Si phase having an equivalent circle diameter equal to or larger than 0.5 µm was targeted. In consideration of analysis accuracy of current analysis apparatuses of EDS and EBSD, fine ones smaller than 0.5 µm were excluded from the target. Subsequently, the number Ns of the Si phases having an equivalent circle diameter in a range equal to or larger than 0.5 µm and equal to or smaller than 0.8 µm was counted. The ratio of Ns to Nc [Ns/Nc × 100 (%)] (small-diameter ratio of the Si phase) was then calculated.

The small- diameter ratio of the Si phase was defined as an average value (arithmetic mean) of respective values obtained for measurement regions at three parts through the procedures from (1) to (3) described above.

### (Method for evaluating Al bonding wire or Al bonding ribbon)

The following describes a method for evaluating the Al bonding wire. The wire diameter of the Al bonding wire used for evaluation was Φ300 µm. The semiconductor chip made of Si was used, and as the electrode on the semiconductor chip, used was an alloy having a composition of Al-0.5%Cu deposited to have a thickness of 4 µm. As a substrate, 5 µm of Ni was deposited on an Al alloy. For bonding of the Al bonding wire, a commercially available wire bonder (manufactured by ULTRASONIC ENGINEERING CO., LTD.) was used, and wedge bonding was used for both of the 1st bonding (bonding with the electrode described above on the semiconductor chip) and the 2nd bonding (bonding with the substrate described above). For bonding of the Al bonding ribbon, a fully automatic bonder "BJ955" that is manufactured by Hesse GmbH and equipped with a ribbon bond head was used.

### (Method for evaluating shear force ratio of 1st bonding part)

The method for evaluating the shear force ratio of the 1st bonding part is described. Regarding bonding conditions, with reference to standard conditions for the Al bonding wire, an ultrasonic output and load were set to be slightly higher and the bonding area is secured. The shear force was evaluated by a shear test for measuring the shear force of the 1st bonding part. The 1st bonding was performed at ten parts and the shear test for the 1st bonding part was performed to measure an average value (SH) of the shear force. For measurement of the shear force, a commercially available micro shear force tester (4000-PLUS manufactured by Nordson Corporation) was used. A shear rate was set to be 200 µm/sec, and a height of a shearing tool was set to be 10 µm from an electrode surface. The shear force was measured by fixing, with a jig, a substrate to which the Al bonding wire or the Al bonding ribbon was bonded. Further, a tensile test was performed on five samples, and an average value (PS) of 0.2% proof stress was measured. As a tensile testing machine, "RTF-1225"

(manufactured by A&D Company, Limited) was used, and a tensile speed was set to 10 mm/min. A ratio obtained by dividing the shear force (SH) by the 0.2% proof stress (PS) in the tensile test (SH/PS) was used as the shear force ratio. If the shear force ratio was equal to or larger than 5.2, it was determined that a bonding state was excellent and evaluated as "3". If the shear force ratio was equal to or larger than 4.5 and smaller than 5.2, it was determined that there was no problem in a practical use and evaluated as "2". If the shear force ratio was equal to or larger than 3.5 and smaller than 4.5, it was determined that improvement was required and evaluated as "1". If the shear force ratio was smaller than 3.5, it was determined that there was a problem in a practical use and evaluated as "0". Evaluation results are described in a column of "Shear force ratio" in tables.

### (Method for evaluating shear force ratio under inclined bonding condition)

A bonding sample was prepared under an inclined bonding condition for a power semiconductor having a thin structure or having an element arranged directly below an electrode. The inclined bonding condition was set such that an initial output of ultrasonic waves (Wf) was high and the output gradually decreased during the time to reach a slightly lower final output (Wg). A ratio (Wg/Wf) between the final output and the initial output was set to fall within a range equal to or larger than 0.6 and smaller than 0.85. The load was set to a constant value. Measurement was performed by evaluating the shear force ratio in the same manner as described above. If the shear force ratio was equal to or larger than 5.0, it was determined to be excellent under the inclined bonding condition and evaluated as "3". If the shear force ratio was equal to or larger than 4.3 and smaller than 5.0, it was determined that there was no problem in a practical use and evaluated as "2". If the shear force ratio was equal to or larger than 3.5 and smaller than 4.3, it was determined that improvement was required and evaluated as "1". If the shear force ratio was smaller than 3.5, it was determined that there was a problem in a practical use and evaluated as "0". Evaluation results are described in a column of "Shear force ratio under inclined bonding condition" in the tables.

### (Method for evaluating temperature cycle reliability under inclined bonding condition)

For evaluation of the temperature cycle test, a commercially available thermal shock test apparatus was used. In the temperature cycle test, a temperature rise and a temperature fall are repeated as a sample chamber moves between a low-temperature tank and a high-temperature tank. A temperature of the low-temperature tank was set to be -40°C, and a temperature of the high-temperature tank was set to be 175°C. The test was started in a state in which the sample chamber was present in the high-temperature tank, and a period from when the sample chamber moved to the low-temperature tank until it returned to the high-temperature tank was defined as one cycle. A time during which the sample chamber stayed in each of the low-temperature tank and the high-temperature tank was set to be 20 minutes. A sample that was bonded under the above-described inclined bonding condition was used. After the test was started, the sample was taken out after 1000 cycles, and a shear test was performed on the 1st bonding part. As a value of shear force of the 1st bonding part used for evaluating the temperature cycle reliability, an average value of shear force of 1st bonding parts at five points, which were randomly extracted, was used. Evaluation was performed based on a force ratio (F2/F1) of a shear force value F2 after the temperature cycle test to a shear force value F1 before the temperature cycle test. If the force ratio was smaller than 50%, it was determined that there was a problem in a practical use and evaluated as "0". If the force ratio was equal to or larger than 50% and smaller than 70%, it was determined that improvement was required and evaluated as "1". If the force ratio was equal to or larger than 70% and smaller than 75%, it was determined to be excellent and evaluated as "2". If the force ratio was equal to or larger than 75%, it was determined to be especially excellent and evaluated as "3". "0" and "1" are unacceptable, and "2" and "3" are acceptable. Evaluation results are described in a column of "Temperature cycle reliability under inclined bonding condition" in the tables.

### (Method for evaluating wire breakage during processing)

The method for evaluating wire breakage during processing is described. Wire-drawing processing was performed from a wire diameter of 10 mmφ to a wire diameter of 0.3 mmφ, and the number of times of wire breakage was checked. The feeding speed, the area reduction ratio, and the like as processing conditions for wire-drawing are selected from the conditions described above, and appropriate manufacturing conditions are adjusted or changed for each wire. The length of the drawn Al bonding wire fell within a range from 100 to 200 m, and the number of times of wire breakage was calculated in terms of 100 m. If the number of times of wire breakage was 0, it was determined to be favorable and evaluated as "3". If the number of times of wire breakage was 1, it was determined to be able to be handled by improving the manufacturing condition and evaluated as "2". If the number of times of wire breakage was 2 to 4, lowering of productivity was regarded as a problem and evaluated as "1". If the number of times of wire breakage was 5 or more, it was determined that a practical use was difficult to be achieved and evaluated as "0". Evaluation results are described in a column of "Wire breakage during processing" in the tables.

### (Method for evaluating scratch and scrape on surface)

A surface property of the Al bonding wire or the Al bonding ribbon was evaluated focusing on scratches and scrapes. The wire diameter of the Al bonding wire was 0.3 mmφ. A thickness of the Al bonding ribbon was 100 µm, and a width thereof was 600 µm. Measurement regions at three parts were randomly selected at intervals of 1 m or more with respect to the center axis direction of the Al bonding wire or the Al bonding ribbon, and three samples each having a length of about 2 cm were taken at each of the three parts to observe nine samples in total. The surface was observed with magnification in a range from 50-fold to 500-fold by using the SEM. A scratch having a length equal to or larger than 50 µm or a scrape having a length equal to or larger than 30 µm were determined to be defects. Parts of scratches and scrapes were counted. If the number thereof was 0, it was determined to be favorable and acceptable, and evaluated as "3". If the number thereof was equal to or larger than 1 and equal to or smaller than 2, it was determined that there was no problem in a practical use and evaluated as "2". If the number thereof was 3 to 7, it was determined that the surface property was not good, and evaluated as "1". If the number thereof was equal to or larger than 8, it was determined that a practical use was difficult to be achieved and evaluated as "0". Evaluation results are described in a column of "Surface property" in the tables.

The evaluation results of Examples and Comparative Examples are indicated in Table 1 to Table 4. Examples 1 to 30 and Comparative Examples 1 to 7 in Table 1 to Table 3 are results related to the Al bonding wire, and Examples B1 to B3 and Comparative Example B1 in Table 4 are results related to the Al bonding ribbon.

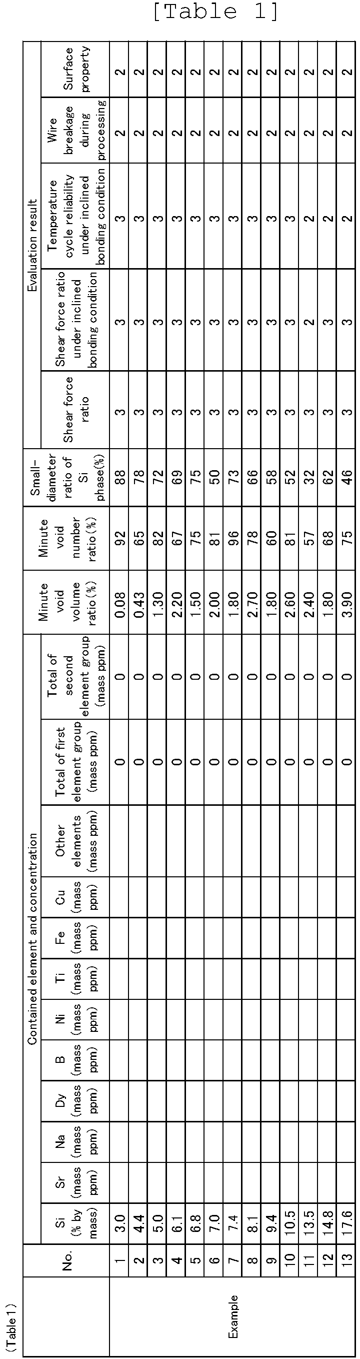

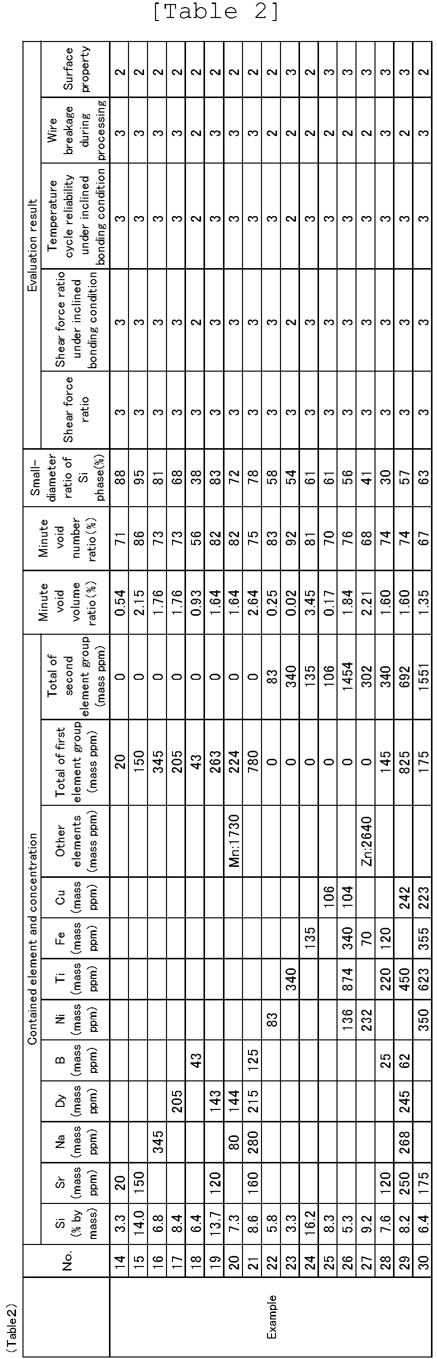

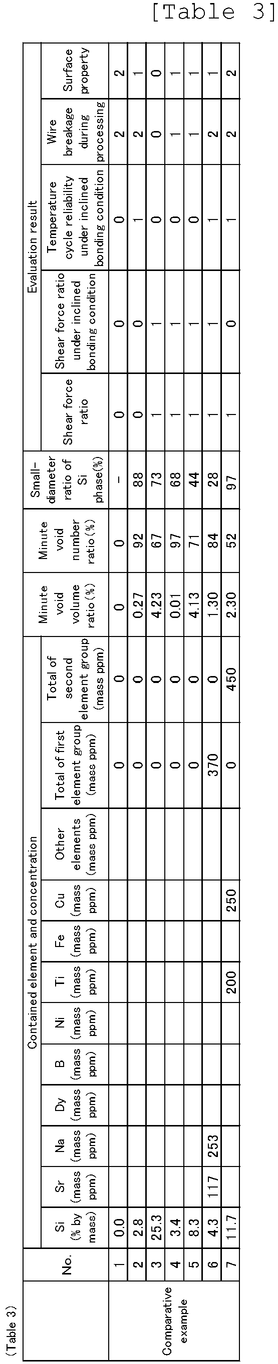

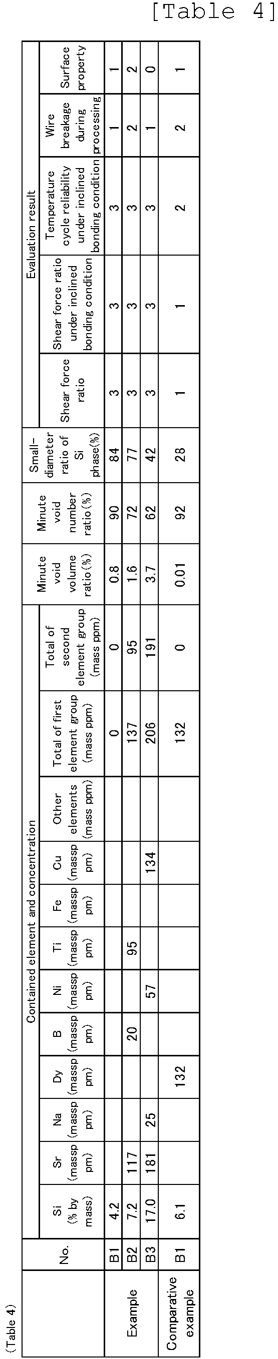

### Reference Signs List

- 1: Al bonding wire
- 10: center axis
- 11: L cross-section
- 2: Al bonding ribbon
- 20: center axis
- 21: L cross-section

## Claims

1. An Al bonding wire or an Al bonding ribbon containing 3.0% by mass or more and 20.0% by mass or less of Si, wherein
in a region observed by X-ray Computed Topograpy (CT) analysis, when a total volume of voids having an equivalent sphere diameter equal to or larger than 1 µm and smaller than 10 µm is defined as Vs and a total volume of a measurement region is defined as Vc, a ratio of Vs to Vc [Vs/Vc × 100 (%)] is equal to or larger than 0.02% and equal to or smaller than 4.00%, and
when the number of Si phases having an equivalent circle diameter equal to or larger than 0.5 µm and equal to or smaller than 0.8 µm in an L cross-section (cross section in a center axis direction including a center axis) is defined as Ns, and the number of Si phases having an equivalent circle diameter equal to or larger than 0.5 µm in the L cross-section is defined as Nc, a ratio of Ns to Nc [Ns/Nc × 100 (%)] is equal to or larger than 30% and equal to or smaller than 95%.

2. The Al bonding wire or the Al bonding ribbon according to claim 1, wherein, in a region observed by X-ray CT analysis, when a total number of voids having an equivalent sphere diameter equal to or larger than 1 µm and smaller than 7 µm is defined as Ps and a total number of voids having an equivalent sphere diameter equal to or larger than 1 µm is defined as Pc, a ratio of Ps to Pc [Ps/Pc × 100 (%)] is equal to or larger than 60% and equal to or smaller than 98%.

3. The Al bonding wire or the Al bonding ribbon according to claim 1 or 2, further containing 10 mass ppm or more and 800 mass ppm or less of one or more of Sr, Na, Dy, and B in total.

4. The Al bonding wire or the Al bonding ribbon according to any one of claims 1 to 3, further containing 100 mass ppm or more and 1500 mass ppm or less of one or more of Ni, Ti, Fe, and Cu in total.

5. The Al bonding wire or the Al bonding ribbon according to any one of claims 1 to 4, wherein a total concentration of elements other than Al, Si, Sr, Na, Dy, B, Ni, Ti, Fe, and Cu in the Al bonding wire or the Al bonding ribbon is equal to or smaller than 0.5 % by mass.

6. The Al bonding wire or the Al bonding ribbon according to any one of claims 1 to 5, wherein the equivalent circle diameter of the Si phase and the number of the Si phases are values measured by using an SEM-EDS-EBSD apparatus.

7. The Al bonding wire or the Al bonding ribbon according to any one of claims 1 to 6, used for a semiconductor device.

8. A semiconductor device comprising the Al bonding wire or the Al bonding ribbon according to any one of claims 1 to 7.
